(19) Europäisches Patentamt
European Patent Office
Office européen des brevets

(11) Numéro de publication: **0 192 017**
**A1**

# (12) DEMANDE DE BREVET EUROPEEN

(21) Numéro de dépôt: **85870024.8**

(51) Int. Cl.⁴: **G 06 F 15/60**

(22) Date de dépôt: **11.02.85**

(43) Date de publication de la demande: **27.08.86 Bulletin 86/35**

(84) Etats contractants désignés: **AT BE CH DE FR GB IT LI LU NL SE**

(71) Demandeur: **UNIVERSITE CATHOLIQUE DE LOUVAIN**
**Place de l'Université, 1**
**B-1348 Louvain la Neuve(BE)**

(72) Inventeur: **Jespers, Paul**
**K. Van Lorreinen Laan 4**
**B-1980 Tervuren(BE)**

(72) Inventeur: **De Muelenaere, Pierre**
**Rue des Cailloux 32**
**B-1330 Rixensart(BE)**

(72) Inventeur: **Legat, Jean-Didier**
**Avenue des Volontaires 245**
**B-1150 Bruxelles(BE)**

(72) Inventeur: **Deleuze, Philippe**
**Rue de Berlicot 1**
**B-5073 Meeffe(BE)**

(74) Mandataire: **Thirion, Robert et al,**
**Bureau GEVERS S.A. 7, rue de Livourne Bte 1**
**B-1050 Bruxelles(BE)**

(54) **Procédé pour le traitement d'informations et processeurs pour la mise en oeuvre de ce procédé.**

(57) Procédé pour le traitment d'informations d'un document suivant lequel on transforme ces informations en signaux numériques analysés grâce à des algorithmes, on fait exécuter l'algorithme primaire par un processeur, on simules l'exécution de l'algorithme primaire sur un ordinateur pour déterminer points critiques et tâches les plus répétitives, on isole ces tâches pour les attribuer à des processeurs dédicacés pour leur exécution, on fait travailler, suivant un microprogramme, chacun desdits processeurs comprenant une unité opérative spécialisée constituée par un unité d'adressage (34) et au moins une autre unité d'exécution logique (36) ou arithmétique (35) et processeurs pour la mise en oeuvre de ce procédé.

EP 0 192 017 A1



Croydon Printing Company Ltd

38
40
39
41
43
43
42
34
35
36
37
44
45
45
45
46
Fig. 5.

0192017

L'invention a pour objet un procédé pour le traitement d'informations portées par un document suivant lequel on transforme ces informations en signaux numériques qui sont ensuite analysés grâce à des algorithmes.

Le traitement des documents et la reconnaissance des caractères ne sont pas des domaines nouveaux. De très nombreux algorithmes ont déjà été étudiés et proposés. Il existe sur le marché un grand nombre de lecteurs de documents. Une des principales caractéristiques du traitement d'images est la difficulté d'implanter les algorithmes sur les systèmes informatiques traditionnels. Pour obtenir un temps d'exécution intéressant, il faut absolument recourir à du matériel spécialisé. Le lien entre l'algorithme et l'équipement est direct : ce matériel dédicacé ne peut généralement pas être utilisé pour implanter d'autres algorithmes.

On propose à présent un procédé original qui repose sur une architecture particulière et susceptible d'être appliquée à de nombreux systèmes ou algorithmes.

Les principales qualités dudit procédé sont les suivantes:

- un caractère général qui permet l'implantation rapide de nombreux algorithmes,
- une puissance de calcul élevée par la présence de nombreuses ressources combinatoires spécifiques,
- L'unité de traitement du processeur peut être implantée dans un circuit intégré dédicacé, ce qui permet de réduire sa complexité tout en maintenant ses performances.

A cet effet, suivant l'invention, on fait exécuter l'algorithme primaire par un processeur à une fréquence d'horloge élevée, on simule l'exécution de l'algorithme primaire sur un ordinateur pour déterminer les points critiques et les tâches les plus répétitives de cet algorithme primaire, on isole ces tâches pour les attribuer à des processeurs dédicacés pour leur exécution, on fait travailler, suivant un microprogramme regroupant des algorithmes secondaires de ces diverses tâches les plus répétitives chacun desdits processeurs qui comprennent une unité opérative spécialisée constituée par une unité d'adressage et au moins une autre unité d'exécution logique ou arithmétique.

L'invention a également pour objet des processeurs pour la mise en oeuvre du procédé susdit.

Il existe déjà des processeurs spécialisés qui réalisent des algorithmes particuliers propres à un système et qui ne peuvent que difficilement ou pas du tout être utilisés dans d'autres systèmes.

Si l'on utilisait les méthodes et moyens connus pour réaliser un processeur pouvant être aisément implanté, on parviendrait à un processeur extrêmement complexe et surtout extrêmement lent.

L'invention a pour but de remédier à ces inconvénients et de procurer un processeur compact, rapide et pouvant être aisément implanté.

Suivant une forme de réalisation avantageuse de l'invention, l'unité opérative du processeur comprend une unité d'adressage, une unité logique, une unité arithmétique et une unité de calcul des fonctions spéciales.

D'autres détails et particularités de l'invention ressortiront de la description des dessins annexés au présent mémoire et qui illustrent, à titre d'exemple non limitatif, le procédé et le processeur suivant l'invention.

La figure 1 est un organigramme de l'algorithme primaire.

La figure 2 est un schéma bloc du procédé de traitement suivant l'invention.

La figure 3 est un exemple d'un algorithme secondaire.

La figure 4 est un schéma bloc d'un processeur dédicacé suivant l'invention.

La figure 5 est un schéma bloc de l'unité opérative du processeur montré à la figure 4.

Le procédé suivant l'invention est notamment destiné au traitement d'informations, telles que textes, photos, graphiques...,portées par des documents. Suivant ce procédé , on transforme lesdites informations en signaux numériques que l'on analyse grâce à des algorithmes. Les algorithmes mis en oeuvre peuvent varier d'une application à l'autre. On peut toutefois déterminer des routines de base qui se retrouvent dans la plupart des méthodes. Ces routines sont la partie critique du système en ce qui concerne la vitesse d'exécution. La tâche qui consiste à enchaîner ces routines, à traiter les résultats et à contrôler le bon déroulement de l'algorithme, ne fait pas appel à des fonctions spécialisées et peut sans problème être exécutée par un système processeur classique. Ce n'est pas le cas pour les routines de base. Ces routines sont réunies dans un microprogramme défini comme un système logique spécialisé qui réalise un ensemble d'instructions dédicacées pour un type d'algorithme particulier.

Ces instructions représentent donc les parties critiques et répétitives des algorithmes implantés. La manière dont ces fonctions ont été déterminées est importante. Le but est de couvrir un maximum d'algorithmes afin de rendre le système le plus général possible.

En déterminant les principaux points critiques des algorithmes les plus souvent utilisés et en implantant ces fonctions critiques, on retire au matériel spécialisé le caractère " algorithme sur silicium" pour lui conférer une propriété d'usage général.

La démarche suivie est la suivante : les algorithmes sélectionnés sont étudiés et simulés sur ordinateur en utilisant un langage standard de programmation. Les points névralgiques sont détectés.

On a alors un triple choix :

- la fonction sera réalisée par le microprocesseur standard;
- la fonction sera réalisée par le processeur spécialisé sous la forme d'un microprogramme;
- la fonction sera réalisée par le circuit intégré spécialisé.

Suivant la fréquence d'utilisation des fonctions et la difficulté à les implanter sur un microprocesseur standard, on se tournera vers le second ou le troisième choix.

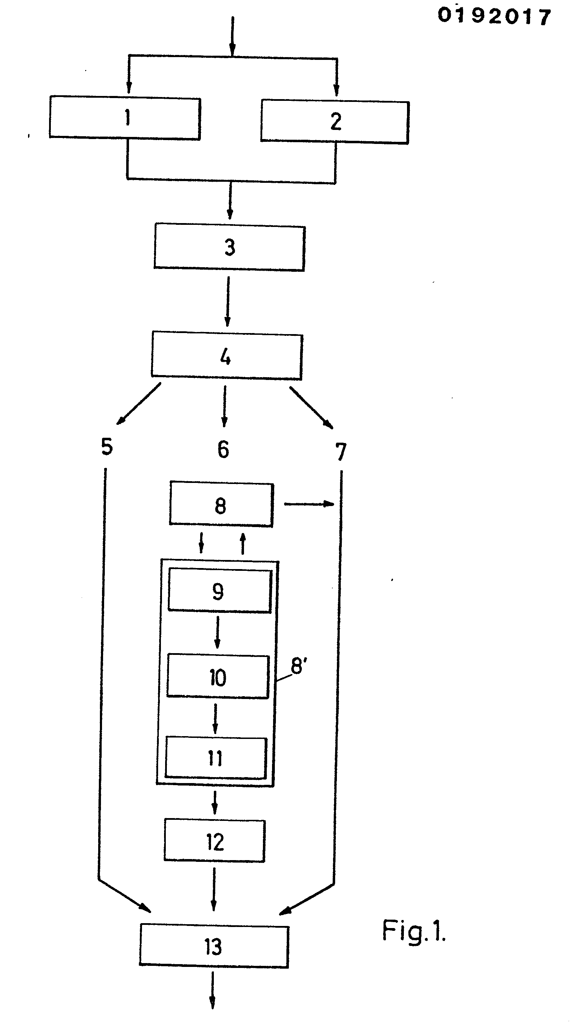

En se référant à la figure 1, on décrira à présent un exemple d'algorithme primaire mis en oeuvre. Les informations provenant de la lecture d'un document subissent, en 1,une binarisation et, en 2, un codage demi-teinte. A partir de ces deux informations, le document subit une segmentation en blocs, en 3, suivie, en 4, par une classification de ces derniers. On obtient ainsi, en 5, des blocs d'image, en 6, des blocs de texte et, en 7, des blocs de graphique. En 8, on procède à une segmentation hiérarchisée des caractères de texte, ces caractères étant reconnus, en 8', et regroupés en lignes, en 12. La reconnaissance des caractères, en 8', étant obtenue de la façon suivante : on transforme les caractères, en 9, on les extrait, en 10, et on les classifie en 11. Les informations provenant de l'étape 12 ainsi que les sorties de classification pour image, en 5, et pour graphique, en 7, sont envoyées à une étape de codage de document, en 13.

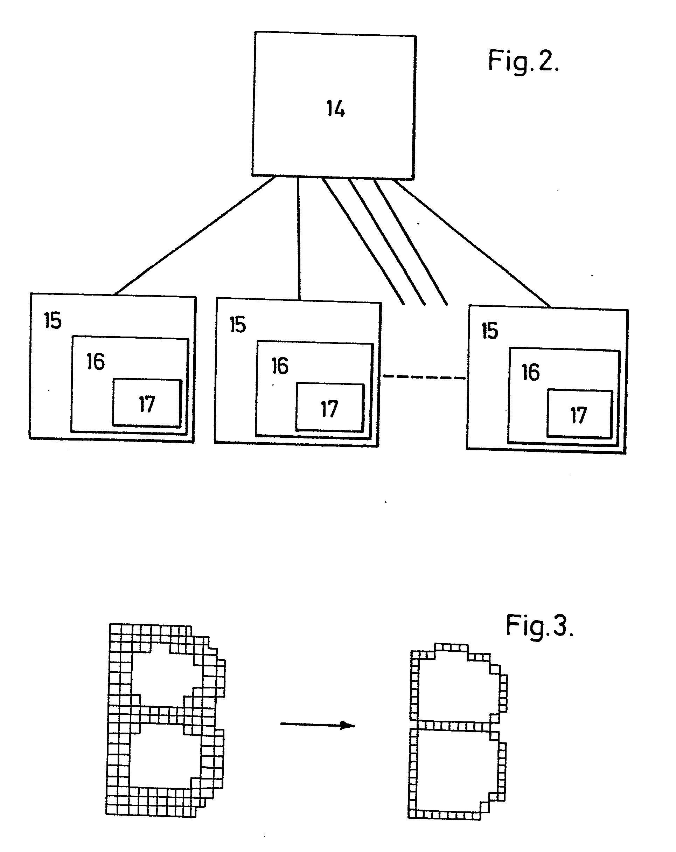

Comme il ressort de la figure 2, le procédé de traitement peut être considéré comme subdivisé en quatre niveaux. Au plus haut niveau, on retrouve un processeur 14, en général dénommé " Master", qui contrôle l'ensemble du système et qui assure le bon déroulement des algorithmes à exécuter.Le deuxième niveau est constitué par des processeurs standards 15 auxquels on associe les principales étapes du traitement (par exemple, la binarisation, la segmentation, la reconnaissance, le codage). Ces processeurs standards 15 exécutent les algorithmes, propres à l'étape qui leur est attribuée. On simule ces algorithmes sur ordinateur pour déterminer les points critiques et les tâches les plus répétitives des algorithmes. Ces tâches seront remplies par des processeurs dédicacés 16, ces derniers constituant le troisième niveau. Chacune de ces tâches les plus répétitives est une partie d'un microprogramme d'un des processeurs dédicacés 16. Au niveau le plus bas, on trouve un circuit intégré spécialisé 17 qui exécute les fonctions élémentaires des algorithmes et qui constitue l'unité de traitement d'un processeur dédicacé microprogrammé.

Un exemple d'algorithme secondaire est illustré à la figure 3. Il s'agit d'un algorithme de squelettisation de caractère. Le processeur dédicacé traite le caractère donné en supprimant des points noirs jusqu'à obtenir une épaisseur des traits d'une unité. Le contrôle de cet algorithme est réalisé par le microprogramme. Les opérations élémentaires sur l'image sont exécutées dans la partie opérative spécialisée.

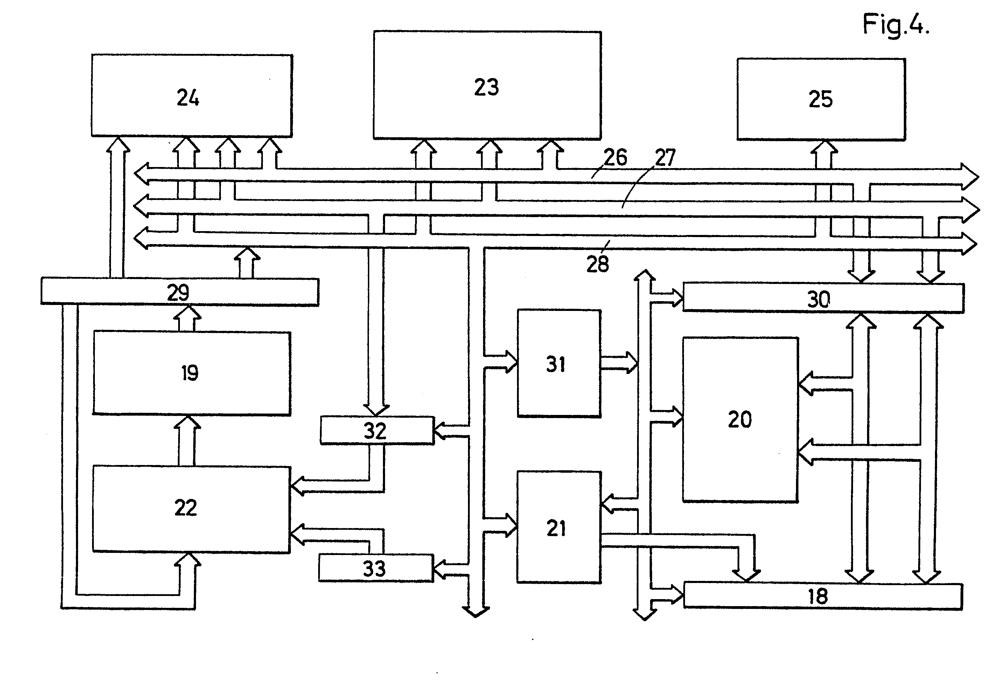

L'architecture type des processeurs dédicacés est donnée à la figure 4. C'est celle d'un processeur microprogrammé. Ce processeur est interfacé, en 18, à un bus standard comme par exemple le VME ou le Multibus non représenté. Une procédure microprogrammée est associée à chaque instruction. L'exécution d'une instruction prend plusieurs cycles d'horloge.

Le microprogramme est enregistré dans des mémoires 19. Il peut donc être assez facilement changé et on peut envisager d'ajouter ou de modifier des instructions dans le cadre d'applications particulières.

Le processeur peut se subdiviser en plusieurs blocs:

- l'interface avec le bus externe 18, tous les transferts d'informations se font par l'intermédiaire d'une mémoire à double accès 20
- le système de gestion pour l'émission et la réception d'interruptions 21
- l'unité de commande 22
- la mémoire de microprogramme 19
- la mémoire d'image 23
- l'unité opérative spécialisée 24

Le processeur dédicacé comprend en outre une horloge de commande 25, un bus d'adressage 26, un bus de données 27, un bus de commande 28, un registre de microinstructions 29, une interface de bus interne 30, une logique d'accès de bus 31, un registre d'instructions 32 et un registre d'état 33.

A l'exception de l'unité opérative 24, les autres parties du processeur sont classiques et sont réalisées à partir de circuits standards. L'unité opérative 24 du processeur dédicacé est par contre tout à fait spéciale. Elle constitue le noeud du système et c'est là que les opérations vont effectivement se dérouler.

Cette unité 24 constitue le dernier niveau dans la matérialisation du système de traitement de documents. Ses caractéristiques sont déterminantes pour les performances générales du système. L'architecture du circuit est particulière et originale. Sa nouveauté ne vient pas essentiellement des éléments dont le circuit est constitué mais plutôt de l'assemblage et du résultat final qui en résulte. Le choix de cette architecture est directement lié au type de problème qu'il a fallu résoudre. Ce choix ne se justifierait absolument pas pour un système logique standard destiné à un usage général.

Dans le cas du traitement de documents, les accès à la mémoire d'image sont très fréquents. Le calcul de l'adresse est donc critique. Les opérations, qui doivent être réalisées sur les données qui proviennent de la mémoire, sont essentiellement logiques. Parallèlement, il est souvent nécessaire d'effectuer des fonctions de comptage. A cela, vient s'ajouter le problème des fonctions spéciales telles que la squelettisation qu'il faut réaliser en un temps minimum.

De ces considérations, il résulte qu'il faut prévoir dans l'unité opérative 24 au moins trois unités distinctes pouvant travailler en parallèle et réalisant simultanément une opération ou un transfert par cycle.

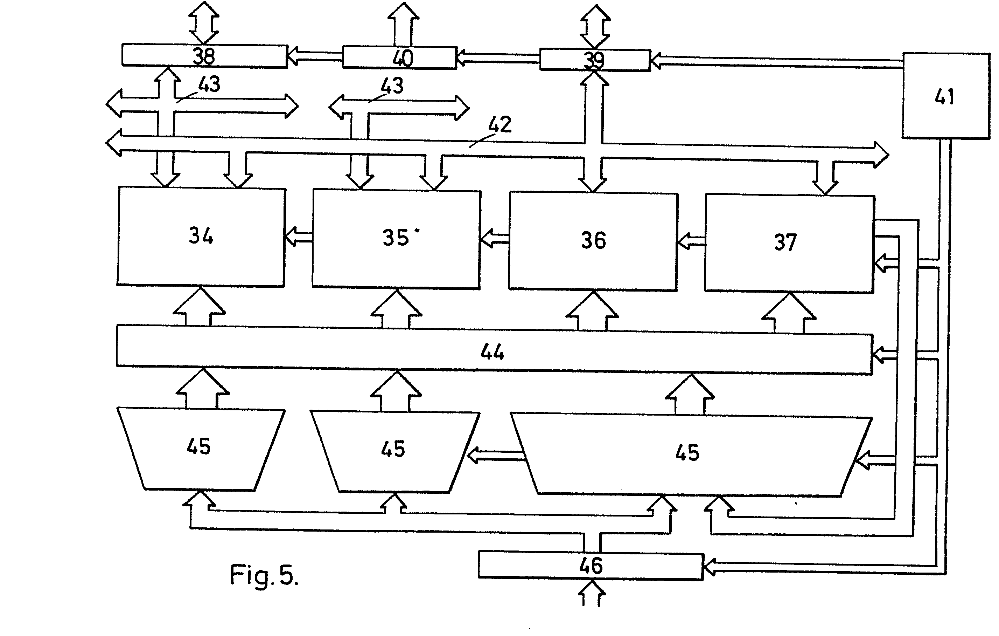

La figure 5 montre, à titre d'exemple, une unité opérative spécialisée 24 constituée de quatre unités distinctes. La première unité 34 est destinée au calcul de l'adresse de la mémoire d'image. L'adresse se subdivise en deux champs : le premier adresse une ligne de l'image, tandis que le second sélectionne une colonne. Cette unité 34 possède un ensemble de registres dont le rôle est de mémoriser des pointeurs de travail ou des valeurs limites comme par exemple les coordonnées de la fenêtre d'image à analyser. L'unité 34 est capable d'effectuer des opérations arithmétiques élémentaires comme l'incrémentation, la décrémentation et la comparaison entre deux adresses.

La seconde unité 35 est une unité arithmétique. Cette unité est destinée à réaliser des opérations arithmétiques du type $A + B$, $A - B$, $A + 1$, $A - 1$, $\frac{A + B}{2}$....Quelques registres mémorisent les paramètres de l'algorithme et certaines valeurs intermédiaires.

La troisième unité 36 est une unité logique. Cette unité 36 a accès à la mémoire d'image 23( voir figure 4), elle reçoit les données, les traite et éventuellement modifie le contenu de la mémoire. Ces opérations sont essentiellement logiques (fonctions booléennes AND, OR, NOT, SHIFT) à l'exception d'une ressource qui permet le calcul rapide de la densité en déterminant, en un cycle, le nombre de points noirs contenus dans un mot. L'unité logique possède également une ressource booléenne pour le calcul de masques ainsi qu'un "barrel shifter".

En effet, en fonction des données que l'on reçoit de la mémoire, il est souvent nécessaire d'incrémenter ou de décré- menter un paramètre. La possibilité de faire ces opérations en parallèle permet un gain de temps important.

La quatrième unité 37 est une unité de calcul des fonctions spéciales. Dans cette unité 37, toutes les fonctions particulières sont implantées dans un réseau logique programmable. (PLA : programmable logic array). Certaines de ces fonctions ne peuvent être réalisées en un cycle et sont séquentialisées. L'unité 37, pour ces opérations, est autonome pendant quelques cycles et se comporte comme une petite machine séquentielle à part entière.

Suivant le programme qu'elle contient, l'unité 37 peut être utilisée pour effectuer des opérations de transformation d'image binaire, comptage de caractéristiques d'image binaire, codage d'image en demi-teinte et opérations de multiplication et/ou division utiles pour le traitement d'image en niveaux de gris (binarisation, prétraitement).

S'il fallait implanter ces unités en utilisant des circuits standards, la complexité du processeur deviendrait telle qu'il perdrait tout son intérêt. L'option a été prise d'intégrer toute l'unité de traitement dans un circuit intégré spécialisé. Un circuit de ce type est nouveau ., il n'existe pas d'équivalent sur le marché des composants.

On a encore représenté à la figure 5 les éléments suivants de l'unité opérative 24:

- 38 : port d'adressage
- 39 : port de données
- 40 : port des variables d'état
- 41: générateur des phases d'horloge
- 42 : bus principal
- 43 : bus local
- 44 : amplificateurs des signaux de commande
- 45: décodeur
- 46 : code opératif

Suivant ce procédé, deux processeurs dédicacés micro- programmés ont été conçus et exécutent les tâches critiques.

Le premier de ces processeurs dédicacés, dénommé DAN (Document Analysis), est spécialisé pour l'analyse de documents et la segmentation des caractères. Il fournit un jeu d'instructions dans les domaines suivants :

- segmentation en blocs qui se base sur la détection de zones frontières où la densité d'informations ou de points noirs est faible
- classification des blocs en trois types "Image-graphique-texte".

Une double représentation des informations est fournie au processeur : une représentation binaire et une représentation demi-teinte qui rend mieux la notion de gris et qui permet une meilleure représentation des images et des photographies. La détection des images se fait en étudiant la corrélation entre les deux représentations. Le texte et le graphique sont séparés sur base des capacités du système de segmentation à délimiter des caractères et du système de reconnaissance à les reconnaître.

- la segmentation des caractères.

La segmentation des caractères se base sur une approche hiérarchisée et itérative du problème. Les principaux algorithmes implantés sont les suivants :

- segmentation par détection de colonnes blanches.
- segmentation par détection de contour.
- segmentation par histogramme.
- segmentation par décision arbitraire.

Tout le document n'est pas entièrement stocké dans la mémoire d'image 23. Cela nécessiterait une mémoire de trop grande capacité. Seules quelques lignes sont mémorisées. Le nombre de ces lignes doit être au moins égal à la hauteur maximum d'un caractère.

La procédure de traitement comprend plusieurs étapes:

- Le processeur analyse le contenu de la ligne la plus ancienne appelée "ligne de référence".
- Lorsqu'une information est détectée, le processeur initialise une procédure de segmentation pour isoler l'information.

- Le processeur classifie l'information et traite son contenu.
- Lorsque le traitement est terminé, la mémoire d'image est effacée.

Le processeur poursuit l'analyse de la "ligne de référence" et, si une nouvelle information est détectée, il initialise la procédure de segmentation susdite.

- Lorsque l'analyse de la "ligne de référence"est terminée, une nouvelle ligne est lue et mémorisée à la place de la "ligne de référence". La position de la ligne de référence est incrémentée d'une position.

Le circuit intégré qui réalise l'unité opérative 24 du processeur DAN ne comporte, dans une de ses versions, qu'une unité d'adressage 34, une unité logique 36 et une unité arithmétique 35, l'unité de calcul des fonctions spéciales 37 étant omise afin de réduire la complexité du processeur.

Le second processeur dédicacé, dénommé STAN (Structural Analysis) est destiné à exécuter les tâches de traitement d'image et d'extraction de caractéristiques utiles pour la reconnaissance des caractères.

En ce qui concerne les images binaires, le processeur STAN fournit un ensemble d'instructions qui permettent de modifier l'image et de calculer des caractéristiques :

- prétraitement binaire
- détection de contour
- squelettisation
- centrage du caractère
- histogramme
- densité de traits
- comptage de caractéristiques

En ce qui concerne les images en niveaux de gris, le processeur STAN peut exécuter des algorithmes de :

- binarisation
- prétraitement (lissage, etc.)

- codage demi-teinte

Les fonctions réalisées par le processeur dépendent en partie du programme implanté dans le réseau logique programmable 37.

Une propriété particulière du processeur STAN est qu'il a été conçu pour être facilement extensible à une machine "array processor". Dans ce cas, l'image est découpée en un ensemble de sous-images, un processeur étant associé à chaque sous-image ou à un groupe de sous-images. Chaque processeur travaille en parallèle sur sa zone d'image.

Le circuit intégré qui réalise l'unité opérative 24 du processeur STAN ne comporte, dans une de ses versions, qu'une unité d'adressage 34, une unité arithmétique 35 et une unité de calcul des fonctions spéciales 37, l'unité logique 36 étant omise pour réduire la complexité du processeur.

Il doit être entendu que l'invention n'est nullement limitée aux formes de réalisation décrites et que bien des modifications peuvent être apportées à ces dernières sans sortir du cadre du présent brevet.

## REVENDICATIONS.

1. Procédé pour le traitement d'informations portées par un document suivant lequel on transforme ces informations en signaux numériques qui sont ensuite analysés grâce à des algorithmes, ledit procédé étant caractérisé en ce qu'on fait exécuter l'algorithme primaire par un processeur à une fréquence d'horloge élevée, on simule l'exécution de l'algorithme primaire sur un ordinateur pour déterminer les points critiques et les tâches les plus répétitives de cet algorithme primaire, on isole ces tâches pour les attribuer à des processeurs dédicacés(16) pour leur exécution, on fait travailler, suivant un microprogramme regroupant des algorithmes secondaires de ces diverses tâches les plus répétitives chacun desdits processeurs qui comprennent une unité opérative spécialisée (24) constituée par une unité d'adressage (34) et au moins une autre unité d'exécution logique (36) ou arithmétique (35).

2. Procédé suivant la revendication 1, caractérisé en ce qu'on incorpore dans l'unité opérative spécialisée (24), en plus de l'unité d'adressage (34), une unité logique (36) et une unité de calcul des fonctions spéciales (37).

3. Procédé suivant la revendication 1, caractérisé en ce qu'on incorpore dans l'unité opérative spécialisé (24), en plus de l'unité d'adressage (34), une unité arithmétique (35) et une unité de calcul des fonctions spéciales (37).

4. Procédé suivant la revendication 1, caractérisé en ce qu'on incorpore dans l'unité opérative spécialisée (24), en plus de l'unité d'adressage (34), une unité logique (36) et une unité arithmétique (35).

5. Procédé suivant la revendication 1, caractérisé en ce qu'on incorpore dans l'unité opérative spécialisée (24), en plus de l'unité d'adressage (34), une unité logique (36), une unité arithmétique (35) et une unité de calcul des fonctions spéciales (37), les tâches les plus répétitives précitées pouvant être attribuées à un seul processeur dédicacé.

6. Processeur pour la mise en oeuvre du procédé suivant la revendication 2, caractérisé en ce que son unité opérative(24) comprend une unité d'adressage (34), une unité logique (36) et une unité de calcul des fonctions spéciales (37).

7. Processeur pour la mise en oeuvre du procédé suivant la revendication 3, caractérisé en ce que son unité opérative (24) comprend une unité d'adressage (34), une unité arithmétique (35) et une unité de calcul des fonctions spéciales (37).

8. Processeur pour la mise en oeuvre du procédé suivant la revendication 4, caractérisé en ce que son unité opérative (24) comprend une unité d'adressage (34), une unité logique (36) et une unité arithmétique (35).

9. Processeur pour la mise en oeuvre du procédé suivant la revendication 5, caractérisé en ce que son unité opérative (24) comprend une unité d'adressage (34), une unité logique (36), une unité arithmétique (35) et une unité de calcul des fonctions spéciales (37).

10. Processeur suivant l'une quelconque des revendications 6 à 9, caractérisé en ce que l'unité opérative (24) est implantée dans un circuit intégré.

11. Processeur suivant l'une quelconque des revendications 6 à 10, caractérisé en ce que son microprogramme est implanté dans une mémoire (19) afin de rendre celui-ci modifiable.

1
2
3
4
5
6
7
8
9
10
8'
11
12
13

Fig. 1.

14
15
16
17
15
16
17
15
16
17

Fig. 2.

Fig. 3.

Fig.4.

24
23
25
26
27
28
29
30
19
31
20
32
22
21
33
18

41
37
36
35'
34
39
40
38
42
43
43
44
45
45
45
46

Fig.5.

Office européen des brevets

**RAPPORT DE RECHERCHE EUROPEENNE**

0192017

Numéro de la demande

EP 85 87 0024

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl.4) |
|---|---|---|---|
| A | IBM TECHNICAL DISCLOSURE BULLETIN, vol. 24, no. 2, juillet 1981, pages 1231-1233, New York, US; J. DUBIL: "Simulation technique for an image processing system" * En entier * --- | 1 | G 06 F 15/60 |
| A | CONFERENCE PROCEEDINGS OF THE 10th ANNUAL INTERNATIONAL SYMPOSIUM ON COMPUTER ARCHITECTURE, 1983, Stockholm, pages 379-386, Computer Society Press, Los Angeles, US; G. GAILLAT: "The design of a parallel processor for parallel processor for image processing on-board satellites: an application oriented approach" * Page 379, colonne de droite, ligne 1 - page 381, colonne de gauche, ligne 32; page 381, colonne de droite, lignes 47-60; page 382, colonne de gauche, lignes 1-17; page 385, colonne de gauche, lignes 27-29; figures 1,3,4 * ----- | 1-11 | DOMAINES TECHNIQUES RECHERCHES (Int. Cl.4) G 06 F 15/60 G 06 F 15/66 |

Le présent rapport de recherche a été établi pour toutes les revendications

| Lieu de la recherche | Date d'achèvement de la recherche | Examinateur |
|---|---|---|
| LA HAYE | 08-10-1985 | BURGAUD C. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82